(19) Europäisches Patentamt
European Patent Office
Office européen des brevets

(11) EP 1 620 442 B1

(12) **EUROPÄISCHE PATENTSCHRIFT**

(45) Veröffentlichungstag und Bekanntmachung des Hinweises auf die Patenterteilung:
**23.07.2008 Patentblatt 2008/30**

(21) Anmeldenummer: **04724007.2**

(22) Anmeldetag: **29.03.2004**

(51) Int Cl.:
***C07F 1/08*** *(2006.01)*

(86) Internationale Anmeldenummer:
**PCT/EP2004/003313**

(87) Internationale Veröffentlichungsnummer:
**WO 2004/096816 (11.11.2004 Gazette 2004/46)**

(54) **DIKUPFER(I)OXALAT-KOMPLEXE ALS PRECURSOR ZUR METALLISCHEN KUPFERABSCHEIDUNG**

DICOPPER (I) OXALATE COMPLEXES AS PRECURSOR FOR METALLIC COPPER DEPOSITION

COMPLEXES D'OXALATE DE DICUIVRE(I) COMME PRECURSEURS POUR LE DEPOT DE CUIVRE METALLIQUE

(84) Benannte Vertragsstaaten:
**AT BE BG CH CY CZ DE DK EE ES FI FR GB GR HU IE IT LI LU MC NL PL PT RO SE SI SK TR**

(30) Priorität: **29.04.2003 DE 10319454**

(43) Veröffentlichungstag der Anmeldung:
**01.02.2006 Patentblatt 2006/05**

(73) Patentinhaber: **BASF SE**
**67056 Ludwigshafen (DE)**

(72) Erfinder: **KÖHLER, Katrin**
**37073 Göttingen (DE)**

(56) Entgegenhaltungen:
**WO-A-00/08225**
**WO-A-00/63461**
**WO-A-20/04000850**
**US-A- 4 387 055**

- **KOEHLER, KATRIN ET AL: "Dicopper(I) Oxalate Complexes Stabilized by Lewis Bases: Potential Precursors for Copper Deposition" ORGANOMETALLICS , 22(22), 4426-4432 CODEN: ORGND7; ISSN: 0276-7333, 2003, XP002285582**
- **DIEZ ET AL: "Preparation of new mono and polynuclear bis(triphenylphosphine) copper(I) derivatives containing mono and bidentate N-heterocycles, 8-hydroxyquinoline and oxalate ligands" CAPLUS, 1988, XP002253106**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft Dikupfer(I)oxalat-Komplexe stabilisiert durch neutrale Lewis-Basen wie Alkene oder Alkine und die Verwendung von Dikupfer(I)oxalat-Komplexen als Precursor für die Abscheidung von metallischem Kupfer, in denen als neutrale Lewis-Basen Alkine, Alkene, Triarylphosphine, CO und Isonitrile verwendet werden.

1. Stand der Technik und Aufgabe der Erfindung

Zur Abscheidung dünner Kupferfilme auf Substraten sind inzwischen viele Kupfer-organische Precursor bekannt. Dabei haben sich als vielversprechende Substanzen Kupfer-Verbindungen in der Oxidationsstufe +1 erwiesen, die einen β-Diketonat-Liganden und eine neutrale Lewis-Base L wie zum Beispiel ein Alken oder ein Alkin enthalten. Derartige Komplexe und deren Verwendung als Precursor im CVD-Prozeß (Chemical Vapor Deposition) sind zum Beispiel in US 5,220,044, WO 00/71550, WO 00/17278, US 6,130,345 oder in Chem. Mater. 2001, 13, 3993; Inorg. Chem. 2001, 40, 6167; Chem. Mater. 1992, 4, 365; Organometallics 2001, 20, 4001 beschrieben. Bevorzugt werden Fluorhaltige β-Diketonat-Liganden wie zum Beispiel Hexafluoroacetylacetonat eingesetzt, da die dazu korrespondierenden Kupfer (I)-Komplexe eine viel höhere thermische Stabilität und eine höhere Flüchtigkeit aufweisen als ihre Fluor-freien Analoga. Fluor-freie Kupfer(I)-β-diketonat-Komplexe wie zum Beispiel Alkin-stabilisierte Kupfer(I)acetylacetonate sind extrem Sauerstoff-empfindlich, zersetzen sich bereits bei 0°C (Chem. Ber. 1995, 128, 525) und sind damit nicht mehr als Precursor für den CVD-Prozeß geeignet. Die Abscheidung der Kupferschicht erfolgt in einer thermisch induzierten Disproportionierung gemäß der nachfolgenden Gleichung:

$$2\ LCu^{I}(\beta\text{-diketonat}) \rightarrow Cu^{0} + Cu^{II}(\beta\text{-diketonat})_2 + 2\ L$$

Das entstehende $Cu^{II}$(β-diketonate) und die Lewis-Base L sind unter den im CVD-Prozeß verwendeten Bedingungen flüchtig und können somit aus dem System entfernt werden. Zurück bleibt idealerweise ein hochreiner Kupferfilm. In dieser Reaktion können jedoch nur 50 % des eingesetzten Kupfer(I)-Precursors in Kupfer(0) umgewandelt werden, die restlichen 50 % enden im entsprechenden $Cu^{II}$ (β-diketonat)$_2$. Das gleiche Ergebnis wird bei der Verwendung von β-Ketoestern anstelle von β-Diketonen erhalten, wie zum Beispiel in WO 00/08225 oder in US 5,441,766 beschrieben. Als nachteilig hat sich jedoch bei Verwendung von Fluor-haltigen Kupfer(I)-Precursor erwiesen, dass die Haftung der Kupferfilme auf verschiedenen Substratoberflächen nicht optimal ist, was wahrscheinlich auf die van der Waals Kräfte der Fluoratome im Precursor-Molekül und damit auf abstoßende Wechselwirkungen zurückgeführt werden kann. Zudem besteht in der Mikroelektronic die Gefahr der Kontamination des Wafers speziell des Siliciums mit Fluor, was zur Unbrauchbarkeit des Wafers führt.

Einen vollständigen Umsatz an Kupfer wird mit Lewis-Basenstabilisierten Kupfer(1)-alkoxiden der Formel LCu (I)OR (EP 0468396) und mit Lewis-Basen-stabilisierten Kupfer(I)cyclopentadienylen der Formel LCu(I)($\eta^5$-$C_5R_5$), beschrieben in EP 0297348 und DE 4123686, erreicht. Zum Teil sind die Beispiele in den genannten Patenten sogar Fluorfrei und bei 25°C stabil. Da jedoch die thermischen Zersetzungsreaktionen radikalische Spezies gebildet, die leider zu verunreinigten Kupferfilmen (Sauerstoff ca. 5 %, Kohlenstoff ca. 1 %) führen (MRS Bulletin/August 1994, 41; Chem. Mater. 1992, 4, 577).

Die WO 00/08225 A offenbart (Cu(I)-Verbindungen, die einen neutralen Liganden, z.B. ein ungesättigter Kohlenwasserstoff, und einen geladenen Acetoacetatliganden aufweisen.

Die WO 2004/000850 betrifft Dikupfer(I)oxalat-Komplexe stabilisiert durch neutrale Lewis-Basen-Bausteine und deren Verwendung als Precursor für die Abscheidung von metallischem Kupfer. Als neutrale Lewis-Basen werden Alkine oder Alkene, welche mindestens eine Silyl- oder Estergruppe enthalten, oder Nitrile, gesättigte und ungesättigte Stickstoff-Liganden, Phosphite, Trialkylphosphine, sauerstoff- und schwefelhaltige Liganden verwendet.

Aufgabe der vorliegenden Erfindung war es daher, Fluor-freie, einfach und kostengünstig herstellbare (Kupfer (I)-Precursor für die Abscheidung von metallischem Kupfer zur Verfügung zu stellen, die thermische und möglichst gegenüber Luft stabil sind, sich thermisch in einer definierten Zersetzungsreaktion im Temperaturbereich von ca. 50 - 400°C unter Bildung definierter molekularer, Kupfer-freier, ungiftiger und möglichst gasförmiger Nebenprodukte vollständig zu metallischen Kupferfilmen umsetzen lassen. Weitere Aufgaben der vorliegenden Erfindung bestehen darin, neben einem einfach und kostengünstig durchführbaren

Verfahren zur Herstellung der erfindungsgemäßen Precursor-Substanzen auch ein geeignetes Verfahren zur Herstellung dünner hochreiner Kupferfilme oder-schichten mit Hifle dieser Precursor zur Verfügung zu stellen und somit auch verbesserte hochreine dünne Kupferschichten.

Erfindungsgemäß werden die Verbindungen der allgemeinen Formel (II) zur Herstellung von hochreinen dünnen Kupfermetallschichten verwendet,

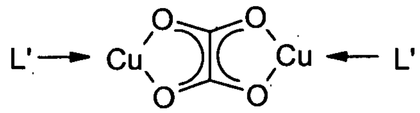 (II),

worin Kupfer in der Oxidationsstufe +1 vorliegt, und

- L' ein ungesättigter Kohlenwasserstoff mit mindestens einer olefinischen oder acetylenischen Gruppe, oder CO, $PAryl_3$ oder Isonitril RN≡C
  mit
- R A, Aryl oder Alkylaryl
  und
- A geradkettig oder verzweigtes C1-C30-Alkyl, C3-C30-Cycloalkyle, geradkettig oder verzweigtes C2-C30-Alkenyl, geradkettig oder verzweigtes C3-C30-Cycloalkenyl
- Aryl C6-C10-Aryle
- Alkylaryl C7-C18-Alkylaryle
  bedeuten, wobei Verbindungen, bei denen
- L' R-C≡CR' mit mindestens einer Silyl- oder Estergruppe, R'HC=CHR mit mindestens einer Silyl- oder Estergruppe, $R'_3Si$-C≡C-R', $R'_3N$, $R'_2N(CH_2)_nNR'_2$, $P(OR')_3$, R'-O-R', $R'-O(CH_2)_n-O-R'$, R'-S-R', $R'-S(CH_2)_nS-R'$
  mit
- R A, Aryl, Alkylaryl oder Alkinyl mit mindestens einer $SiR'_3$- oder COOR'-Gruppe und
- R' Alkinyl,

bedeuten,
ausgenommen sind.

Gute Ergebnisse werden mit den Verbindungen der allgemeinen Formel (II) erhalten, in denen

- L' ein ungesättigter Kohlenwasserstoff aus der Reihe der offenkettigen C2-C30 Alkene und zyklischen C4-C30 Alkene, der offenkettigen C2-C30 Alkine oder zyklischen C10-C30 Alkine, CO, $PAryl_3$ oder RN≡C
  mit
- R A
- Aryl Phenyl
  und
- A geradkettig oder verzweigtes C1-C30-Alkyl, C3-C30-Cycloalkyl

ist.

Besonders gute Ergebnisse werden mit den Verbindungen der allgemeinen Formel (II) erreicht, in denen

- L' ein ungesättigter Kohlenwasserstoff aus der Reihe der offenkettigen C2-C15 Alkene oder zyklischen C4-C15 Alkene, der offenkettigen C2-C15 Alkine oder zyklischen C10-C15 Alkine, oder CO, $P(C_6H_5)_3$ oder RN=C
  mit
- R A
- A geradkettig oder verzweigtes C1-C8-Alkyl, C3-C10-Cycloalkyl ist.

Ganz bevorzugt sind aus dieser Gruppe Verbindungen, in denen für das offenkettige C2-C15 Alken Ethen, Propen, die Isomere von Buten, Penten, Hexen, Hepten, Okten, Nonen oder Decen steht, und/oder für das zyklische C4-C15 Alken Cyclobuten, Cyclopenten, Cyclohexen, Cyclohepten, Cyclookten, Cycopentadien, Cyclohexadien, Cyclooktadien, Norbornen, Norbornadien steht, die mit einem Kohlenwasserstoff substituiert sein können und/oder für das offenkettige C2-C15 Alkin steht Acetylen, Propin, die Isomere von Butin, Pentin, Hexin, Heptin, Oktin, Nonin, Decin oder Diphenylacetylen, und/oder für das zyklische C10-C15 Alkin steht Cyclodecin, Cyclodecadiin, Cyclododecin oder Cycododecadiin, die mit einem Kohlenwasserstoff substituiert sein können.

Gleichwertig bevorzugt sind Verbindungen in denen L' steht für die Isonitrile Cyclohexylisonitril oder Phenylisonitril.

Die Lösung der erfindungsgemäßen Aufgabe erfolgt vorzugsweise durch Verbindungen der allgemeinen Formel (I)

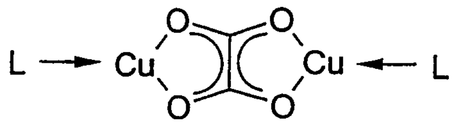

(I),

worin Kupfer in der Oxidationsstufe +1 vorliegt, und

| | |
|---|---|
| L | ein Kohlenwasserstoff aus der Reihe offenkettiges Alkin der Formel R-C≡C-R' oder zyklisches C10-C20 Alkin oder offenkettiges internes Alken der Formel R"HC=CHR"' oder zyklisches C4-C20 Alken bedeutet<br>mit |
| R, R' | H, A, Alkylaryl oder Alkinyl |
| R", R"' | A, Aryl, Alkylaryl oder Alkinyl,<br>wobei L, R, R', R" und R"' jeweils unabhängig voneinander in verschiedenen Positionen des Moleküls gleiche oder verschiedene Bedeutungen annehmen können,<br>und |
| A | geradkettig oder verzweigtes C1-C30-Alkyl, C3-C30-Cycloalkyle, geradkettig oder verzweigtes C2-C30-Alkenyl, geradkettig oder verzweigtes C3-C30-Cycloalkenyl |
| Aryl | C6-C10-Aryle |
| Alkylaryl | C7-C18-Alkylaryle |
| Alkinyl | geradkettig oder verzweigtes C2-C30-Alkinyl |

bedeuten. Diese neuen Verbindungen sind dabei ein weiterer Gegenstand der vorliegenden Erfindung.

Erfindungsgemäße Verbindungen sind vorzugsweise auch Verbindungen der allgemeinen Formel (I), worin

| | |
|---|---|
| A | geradkettiges oder verzweigtes C1-C9-Alkyl, geradkettiges oder verzweigtes C3-C9-Cycloalkyl, geradkettiges oder verzweigtes C2-C9-Alkenyl, geradkettiges oder verzweigtes C3-C9-Cycloalkenyl |
| Aryl | Phenyl, Naphthyl, |
| Alkylaryl | Toluyl oder Mesityl, |
| Alkinyl | geradkettige oder verzweigte C2-C9-Alkinyle |

bedeuten

und L, R, R', R" und R"' jeweils unabhängig voneinander in verschiedenen Positionen des Moleküls gleiche oder verschiedene Bedeutungen annehmen können.

Weitere bevorzugte Untergruppen bilden Verbindungen der allgemeinen Formel (1), worin

**I.**

| | |
|---|---|
| A | geradkettige oder verzweigte C1-C4-Alkyle aus der Gruppe Methyl, Ethyl, n- und i-Propyl oder n-, i- und tert-Butyl, C3-C6-Cycloalkyle aus der Gruppe Cyclopropyl, Cyclobutyl, Cyclopentyl und Cyclohexyl, geradkettiges oder verzweigtes C2-C6-Alkenyle aus der Gruppe Vinyl, Propenyl, Butenyl, Pentenyl oder |

Hexenyl, C3-C6-Cycloalkenyle aus der Gruppe Cyclopropenyl, Cyclobutenyl, Cyclopentenyl, Cyclopentadienyl und Methylcyclopentadienyl

| | |
|---|---|
| Aryl | Phenyl, Naphthyl, |
| Alkylaryl | Toluyl oder Mesityl, |
| Alkinyl | geradkettige oder verzweigte C2-C6-Alkinyle aus der Gruppe Ethinyl, Propinyl, Butinyl, Pentinyl oder Hexinyl |

bedeuten
und R, R', R" und R"' jeweils unabhängig voneinander in verschiedenen Positionen des Moleküls gleiche oder verschiedene Bedeutungen annehmen können,
oder

**II.**
worin L ein offenkettiges Alkin ist, ausgewählt aus der Gruppe Me-C≡C-Me, Et-C≡C-Et, Pr-C≡C-Pr oder Bu-C≡C-Bu
oder

**III**.
worin L ein zyklisches Alkin ist, ausgewählt aus der Gruppe Cyclodecin, Cyclodecadiin, Cyclododecin, Cyclododecadiin
oder

**IV.**
worin L ein offenkettiges internes Alken ist, ausgewählt aus der Gruppe HR"C=CHR"', worin R", R"' unabhängig von einander $CH_3$, $C_2H_5$, $C_3H_7$, $C_4H_9$
oder

**V.**
worin L ein zyklisches Alken ist, ausgewählt aus der Gruppe Cyclobuten, Cyclopenten, Cyclopentadien, Cyclohexen, Cyclohexadien, Cyclohepten, Cycloheptadien, Cycloocten, Cyclooctadien, Norbornen oder Norbornadien bedeuten.

Insbesondere bevorzugt erfolgt die Lösung der Aufgabe der vorliegenden Erfindung durch die neuen Verbindungen der allgemeinen Formel(I)

Di[(3-hexin)kupfer(I)]oxalat und

Di[(norbornen)kupfer(I)]oxalat.

Die erfindungsgemäßen Verbindungen bzw. erfindungsgemäß zu verwendende Verbindungen können erhalten werden durch ein Verfahren, indem $Cu_2O$ mit Oxalsäure und einer Lewis-Base L in einem inerten Lösungsmittel umgesetzt wird und das hergestellte Produkt isoliert wird. Dieses Verfahren ist ebenfalls Gegenstand der vorliegenden Erfindung.

Die Herstellung von hochreinen dünnen Kupfermetallschichten, erfolgt durch ein Verfahren, zu dessen Durchführung Verbindungen der allgemeinen Formel (II) erhitzt werden, wodurch die Lewis-Base L' abgespalten und metallisches Kupfer durch Decarboxylierung abgeschieden wird. Auch dieses Herstellverfahren ist Gegenstand der vorliegenden Erfindung.

Die Abspaltung der Lewis-Base L' erfolgt vorzugsweise in einem Temperaturbereich von ca. 50 bis ca. 200 °C. Die als zweite Reaktion erfolgende Decarboxylierung unter Bildung von metallischem Kupfer und Kohlendioxid wird dabei bevorzugt in einem Temperaturbereich von ca. 150 bis 350 °C abgeschlossen.

Die abgespaltene Lewis-Base L' wird vorzugsweise recycelt und erneut in einem Verfahren zur Herstellung der Verbindungen der allgemeinen Formel (II) eingesetzt und zur Herstellung von hochreinen dünnen metallischen Kupferschichten verwendet.

Die Lösung der erfindungsgemäßen Aufgabe erfolgt somit insbesondere durch hochreine dünne metallische Kupferschichten mit verbesserten Eigenschaften, hergestellt unter Verwendung einer Verbindung der allgemeinen Formel (II) in dem erfindungsgemäßen Verfahren.

2. Detaillierte Beschreibung der Erfindung

Durch die vorliegende Erfindung werden Verbindungen der allgemeinen Formel (I)

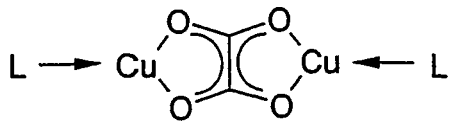

(I)

zur Verfügung gestellt, worin jeweils unabhängig von der Stellung im Komplex und voneinander
L für ein offenkettiges Alkin R-C≡C-R' oder ein zyklisches Alkin steht, oder für ein offenkettiges Alken R"HC=CHR"' oder ein zyklisches Alken steht. Die Oxidationsstufe des Kupfers beträgt +1.
R und R' können unabhängig voneinander H oder Kohlenwasserstoffe aus der Reihe Alkyl, Cycloalkyl, Alkenyl, Cycloalkenyl, Alkylaryl oder Alkinyl sein.
R" und R"' können unabhängig voneinander ein Kohlenwasserstoff aus der Reihe Alkyl, Cycloalkyl, Alkenyl, Cycloalkenyl, Aryl, Alkylaryl oder Alkinyl sein.

Die Herstellung der Verbindung der allgemeinen Formel (I) erfolgt durch Umsetzung von $Cu_2O$, Oxalsäure und dem neutralen Liganden L oder den zwei verschiedenen neutralen Liganden in einem inerten aprotischen organischen Lösungsmittel. Die Verbindungen der allgemeinen Formel (I) lassen sich als Temperatur-stabile Substanzen rein isolieren. Zudem zeichnen sich die erhaltenen Substanzen durch eine überraschend und ungewöhnlich hohe Oxidationsbeständigkeit aus, sie können ohne Probleme an der Luft gehandhabt werden, was die nachfolgende Verwendung der Substanzen als Precursor zur Abscheidung von metallischem Kupfer enorm erleichtert.

Erhitzt man die Verbindungen der allgemeinen Formel (II)

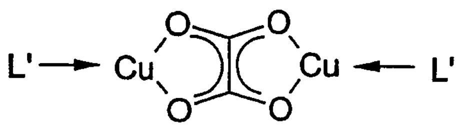

(II),

worin Kupfer in der Oxidationsstufe +1 vorliegt, und

L' ein ungesättigter Kohlenwasserstoff mit mindestens einer olefinischen, oder acetylenischen Gruppe oder CO, $PAryl_3$ oder Isonitril RN≡C

R Alkyl, Cycloalkyl, Alkenyl, Cycloalkenyl, Aryl, Alkylaryl oder Alkinyl,

bedeutet,
so bleibt ein hochreiner Kupferspiegel zurück; alle Nebenprodukte sind flüchtig und können somit sehr einfach vom Reaktionsort entfernt werden. Die thermische Zersetzung läuft nach der folgenden Gleichung ab:

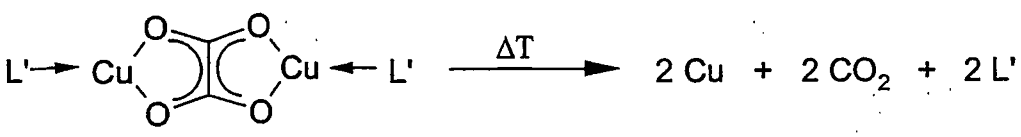


Als Reaktionsprodukte entstehen neben metallischem Kupfer nur Kohlendioxid und die Lewis-Base L', die regeneriert und wiederverwendet werden kann.

Verwenden lassen sich die Verbindungen der allgemeinen Formel (II) als Precursor zur Abscheidung von metallischem Kupfer. Die Abscheidung kann aus der Gasphase oder aus einer Lösung aus Precursor und einem geeigneten Lösungsmittel oder aus dem festen Zustand des Precursor durch Kontakt des Precursors mit einem erhitzten Substrat erfolgen. Vorteilhaft im Vergleich zum Stand der Technik ist, dass erstmals Kupfer(I)-Precursor zugänglich sind, mit denen sich metallisches Kupfer in einer definierten Radikal-freien Zersetzungsreaktion unter Bildung hochreiner

Kupferfilme vorzugsweise quantitativ abscheiden lassen. Damit läßt sich die Ausbeute an abgeschiedenem metallischen Kupfer von 50 auf 100 % im Vergleich zum Stand der Technik erhöhen. Die hohe Stabilität und Unempfindlichkeit der Verbindungen insbesondere die hohe Oxidationsstabilität vereinfacht das Handling der Verbindungen im Verfahren zur Abscheidung von metallischem Kupfer enorm und wirkt sich somit kostengünstig auf den Abscheideprozeß aus.

Die Vorteile der Verbindungen der allgemeinen Formel (II) im Vergleich zu der nach dem Stand der Technik verwendeten Substanz (CupraSelect®) sind somit: bessere physikalische Eigenschaften wie höhere thermische Beständigkeit, bessere chemische Eigenschaften wie höhere Oxidationsstabilität, einfachere Handhabung, kostengünstigere Synthese aufgrund des viel kostengünstigeren Eduktes Oxalsäure im Vergleich zu Hexafluoroacetylaceton, doppelt so hohe Ausbeute an metallischem Kupfer im Abscheideprozeß, Kupfer-freie und ungiftige Nebenprodukte, weniger Nebenprodukte und damit eine geringere Umweltbelastung. Zudem sind keine Fluoratome in den Verbindungen enthalten, die zur Fluor-Kontamination und damit zur Unbrauchbarkeit von Wafern führen können.

Insgesamt ist damit die Synthese der erfindungsgemäßen Kupfer(I)-Precursor einfacher und kostengünstiger als die des kommerziell erhältlichen Kupfer(I)-Precursors CupraSelect®, wobei es sich um (Trimethylvinylsilan)kupfer (I)hexafluoroacetylacetonat handelt. Gleichzeitig kann durch die erfindungsgemäßen Precursor sowohl die Qualität der Kupferbeschichtungen erhöht werden und das Verfahren umweltfreundlicher gestaltet werden.

Erfindungsgemäße Verbindungen der allgemeinen Formel (I) enthalten ein Oxalat-Dianion, zwei Kupfer-Zentren in der Oxidationsstufe +1 und mindestens zwei neutrale Liganden L, wobei das Oxalat-Dianion als Brücke in einem $\mu$-1,2,3,4-Modus an die beiden Kupfer(I)-Zentren gebunden ist. Stabilisiert wird der Dikupfer(I)oxalat-Baustein $CuO_2C_2O_2Cu$ durch Koordination von mindestens zwei neutralen Liganden L an beide Kupfer(1)-Zentrum, vorzugsweise von zwei gleichen Liganden L, so dass beide Kupfer(I)-Zentren mindestens eine pseudo-trigonal-planare, gegebenenfalls auch eine tetraedrische Umgebung aufweisen. Die im Komplex enthaltenen Kupferatome können an zwei unterschiedliche Liganden L gebunden sein. Im folgenden wird zur Vereinfachung allgemein von dem Liganden oder der Lewis-Base L gesprochen, obwohl darunter auch zwei verschiedene Liganden oder Lewis-Basen L verstanden werden können.

L steht für ein offenkettiges Alkin R-C≡C-R' oder zyklisches C10-C20 Alkin oder für ein offenkettiges Alken R"HC=CHR"' oder zyklisches C4-C20 Alken. R und R' wiederum können unabhängig voneinander H, Alkyl, Cycloalkyl, Alkenyl, Cycloalkenyl, Alkylaryle oder Alkinyl. R" und R"' können unabhängig voneinander Alkyl, Cycloalkyl, Alkenyl, Cycloalkenyl, Aryl, Alkylaryl oder Alkinyl sein.

Zyklische C10-C20 Alkine können geradkettig oder verzweigte C10-C20 Cycloalkine sein, bevorzugt geradkettig oder verzweigte C10-C15 Cycloalkine, besonders bevorzugt C10-C12 Cycloalkine aus der Reihe Cyclodecin, Cyclodecadiin, Cyclododecin, Cyclododecadiin.

Zyklische C4-C20 Alkene können geradkettig oder verzweigte C4-C20 Cycloalkene sein, bevorzugt geradkettig oder verzweigte C4-C15 Cycloalkene, besonders bevorzugt C4-C8 Cycloalkene aus der Reihe Cyclobuten, Cyclopenten, Cyclopentadien, Cyclohexen, Cyclohexadien, Cyclohepten, Cycloheptadien, Cycloocten, Cyclooctadien, Norbornen oder Norbornadien.

Alkyl-Gruppen können geradkettig oder verzweigte C1-C30-Alkyle sein, vorzugsweise geradkettige oder verzweigte C1-C9-Alkyle, besonders bevorzugt geradkettige oder verzweigte C1-C4-Alkyle aus der Gruppe Methyl, Ethyl, n- und i-Propyl oder n-, i- und tert-Butyl. CycloalkylGruppen können geradkettig oder verzweigte C3-C30-Cycloalkyle sein, vorzugsweise C3-C9-Cycloalkyle, besonders bevorzugt C3-C6-Cycloalkyle aus der Gruppe Cyclopropyl, Cyclobutyl, Cyclopentyl und Cyclohexyl.

Alkenyl-Gruppen können geradkettig oder verzweigte C2-C30-Alkenyle sein, vorzugsweise geradkettige oder verzweigte C2-C9-Alkenyle, besonders bevorzugt geradkettige oder verzweigte C2-C6-Alkenyle aus der Gruppe Vinyl, Propenyl, Butenyl, Pentenyl oder Hexenyl. Cycloalkenyl-Gruppen können geradkettig oder verzweigte C3-C30-Cycloalkenyle sein, vorzugsweise C3-C9-Cycloalkenyle, besonders bevorzugt C3-C6-Cycloalkenyle aus der Gruppe Cyclopropenyl, Cyclobutenyl, Cyclopentenyl, Cyclopentadienyl und Methylcyclopentadienyl.

Arylgruppen können C6-C10-Aryle sein, vorzugsweise Phenyl oder Naphthyl. Alkylaryle können C7-C18-Alkylaryle sein, vorzugsweise Toluyl oder Mesityl.

Alkinyl-Gruppen können geradkettig oder verzweigte C2-C30-Alkinyle sein, vorzugsweise geradkettige oder verzweigte C2-C9-Alkinyle, besonders bevorzugt geradkettige oder verzweigte C2-C6-Alkinyle aus der Gruppe Ethinyl, Propinyl, Butinyl, Pentinyl oder Hexinyl.

Als neutrale Lewis-Basen eignen sich besonders gut offenkettige Alkine der Formel R-C≡C-R', zyklische Alkine, offenkettige Alkene der Formel R"HC=CHR"' und zyklische Alkene. Vorzugsweise werden offenkettige Alkine aus der Gruppe R-C≡C-R' eingesetzt und besonders gute Ergebnisse werden mit den Alkinen R-C≡C-R' (R, R' = $CH_3$, $C_2H_5$, $C_3H_7$, $C_4H_9$) erhalten. Vorzugsweise werden offenkettige Alkene aus der Gruppe R"HC=CHR"' (R", R"' = $CH_3$, $C_2H_5$, $C_3H_7$, $C_4H_9$) und zyklische Alkene eingesetzt und besonders gute Eigenschaften werden mit den zyklischen Alkenen Cyclohexen und Norbornen erhalten. Besonders gute Ergebnisse werden mit dem Alkin Et-C≡C-Et und dem Alken Norbornen erhalten.

Die Herstellung der Verbindung der allgemeinen Formel (I) erfolgt vorzugsweise durch Umsetzung von $Cu_2O$, Oxalsäure und der Lewis-Base L unter Schutzgasatmosphäre in einem inerten aprotischen organischen Lösungsmittel.

Als Lewis-Base L können zu diesem Zweck zwei verschiedene Lewis-Basen L im äquimolaren Verhältnis eingesetzt werden. Die Reihenfolge der Zugabe der Komponenten kann beliebig gewählt werden. Vorzugsweise werden, wenn als Lewis-Base L ein Gemisch aus zwei entsprechenden Verbindungen eingesetzt werden soll, beide Verbindungen gleichzeitig zu der Reaktionsmischung hinzugefügt oder vor der Zugabe miteinander vermischt werden. Die Ausgangsverbindungen können in einem geeigneten Lösungsmittel vorgelöst bzw. suspendiert oder ohne Lösungsmittel als Feststoff bzw. Flüssigkeit zugegeben werden. Als geeignete Lösungsmittel zur Durchführung der Reaktion können inerte aprotische Lösungsmittel wie offenkettige oder zyklische aliphatische und aromatische Kohlenwasserstoffe, die teilweise halogeniert sein können, oder Ether und zyklische Ether verwendet werden. Besonders bevorzugt ist die Verwendung von Pentan, Hexan, Heptan, Cyclohexan, Toluol, Methylenchlorid, Trichlormethan, Chlorbenzol, Diethylether oder Tetrahydrofuran. Als Schutzgasatmosphäre können Stickstoff oder Argon dienen. Das stöchiometrische Verhältnis der Edukte $Cu_2O$, Oxalsäure und der Lewis-Base L liegt zwischen 1:1:2 und 1:1:4, vorzugsweise zwischen 1:1:2 und 1:1: 3 und besonders bevorzugt bei 1:1:2. Die Lewis-Base L sollte nicht im Unterschuß bezüglich Oxalsäure und $Cu_2O$ zugegeben werden. Die Reaktion kann in einem Temperaturbereich von -30 bis + 100 °C, vorzugsweise von 0 bis 50 °C und ganz bevorzugt zwischen 20 und 40 °C erfolgen. Die höchsten Ausbeuten werden bei Raumtemperatur erhalten. Die Reaktionszeit beträgt zwischen 1 und 24 Stunden, vorzugsweise zwischen 2 und 8 Stunden und ganz bevorzugt zwischen 3 und 6 Stunden. Die Reaktionslösung verändert sich beginnend von einer roten Suspension hin zu einer farblosen oder bräunlichen Lösung oder Suspension je nach Art des entstehenden Komplexes. Die unlöslichen Bestandteile werden abgetrennt. Dieses kann durch Filtration, Zentrifugieren oder andere dem Fachmann bekannte Methoden erfolgen. Man erhält eine klare farblose, gelbe oder rote Lösung je nach Art der eingesetzten Lewis-Base L. Anschließend werden die Verbindungen der allgemeinen Formel (I) isoliert. Dieses kann nach Entfernung des Lösungsmittels nach dem Fachmann bekannten Methoden erfolgen. Gegebenenfalls erfolgt eine weitere Aufreinigung. Anstelle der mechanischen Abtrennung der Feststoffe aus dem Reaktionsgemisch durch Filtration oder andere Methoden kann auch eine Extraktion zur Abtrennung des gebildeten Produktes erfolgen. Die Verbindungen der allgemeinen Formel (I) sind, wie oben bereits beschrieben, überraschend Temperatur-stabil und lassen sich daher gut als reine Substanzen isolieren und anschließend analytisch und spektroskopisch charakterisieren.

Erfindungsgemäße Verbindungen der allgemeinen Formel (II)

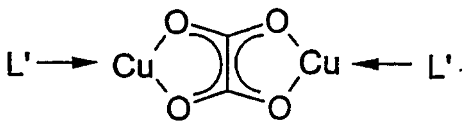 (II),

können zur Herstellung von hochreinen dünnen Kupfermetallschichten verwendet werden.

L' steht für ein offenkettiges Alkin R-C≡C-R', zyklisches Alkin, offenkettiges Alken RHC=CHR', zyklisches Alken, CO, $P(Aryl)_3$ oder Isonitril RN≡C. R und R' wiederum können unabhängig voneinander H, Alkyl, Cycloalkyl, Alkenyl, Cycloalkenyl, Aryl, Alkylaryl oder Alkinyl sein.

Die Bedeutungen für Alkyl, Cycloalkyl, Alkenyl, Cycloalkenyl, Aryl, Alkylaryl oder Alkinyl entsprechen den Bedeutungen in den Verbindungen der allgemeinen Formel (I).

Cycloalkine können geradkettig oder verzweigte C10-C20 Cycloalkine sein, bevorzugt geradkettig oder verzweigte C10-C15 Cycloalkine, besonders bevorzugt C10-C12 Cycloalkine aus der Reihe Cyclodecin, Cyclodecadiin, Cycloundecin, Cycloundecadiin, Cyclododecin, Cyclododecadiin.

Cycloalkene können geradkettig oder verzweigte C4-C20 Cycloalkene sein, bevorzugt geradkettig oder verzweigte C4-C15 Cycloalkene, besonders bevorzugt C4-C8 Cycloalkene aus der Reihe Cyclobuten, Cyclopenten, Cyclopentadien, Cyclohexen, Cyclohexadien, Cyclohepten, Cycloheptadien, Cycloocten, Cyclooctadien, Norbornen oder Norbornadien.

Als neutrale Lewis-Basen L' eignen sich besonders gut offenkettige Alkine der Formel R-C≡C-R', zyklische Alkine, offenkettige Alkene der Formel RHC=CHR', zyklische Alkene, CO, $P(Aryl)_3$ und RN≡C. Vorzugsweise werden offenkettige Alkine aus der Gruppe R-C≡C-R', offenkettige Alkene der Formel RHC=CHR', zyklische Alkene, CO und RN≡C eingesetzt. Besonders gute Ergebnisse werden mit den Alkinen R-C≡C-R' (R, R' = $CH_3$, $C_2H_5$, $C_3H_7$, $C_4H_9$), mit den offenkettigen Alkene RHC=CHR' (R, R' = $CH_3$, $C_2H_5$, $C_3H_7$, $C_4H_9$), mit den zyklischen Alkenen Cyclohexen und Norbornen, mit CO und RN≡C (R = $^tC_4H_9$, $C_6H_{11}$, $C_6H_5$) erhalten. Vorzugsweise werden offenkettige Alkene aus der Gruppe RHC=CHR' (R, R' = $CH_3$, $C_2H_5$, $C_3H_7$, $C_4H_9$), zyklische Alkene Cyclohexen und Norbornen, CO und $C_6H_{11}$N≡C eingesetzt und besonders gute Eigenschaften werden mit dem offenkettigen Alkin Et-C=C-Et, dem zyklischen Alken Norbornen, CO und $C_6H_{11}$N≡C erhalten. Besonders gute Ergebnisse werden mit dem Alkin Et-C≡C-Et und dem Alken Norbornen erhalten.

Das thermische Verhalten der Verbindungen kann mittels TGA (thermogravimetrische Analyse) und DSC (Differential Scanning Calorimetry) untersucht untersucht werden. Durchgeführte Untersuchungen zeigten, dass die Zersetzung der erfindungsgemäßen Verbindungen in 2 Hauptstufen erfolgt:

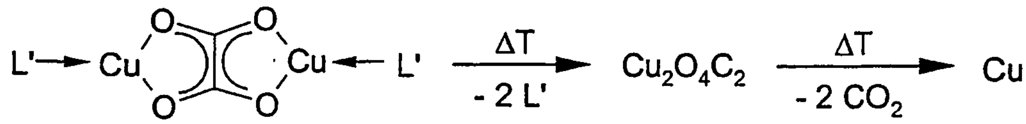


Zuerst spaltet sich die Lewis-Base L' vom Kupfer(I)-Komplex ab. Diese Abspaltung kann je nach Verbindung auch stufenweise erfolgen und durch eine TGA nachgewiesen werden. In der zweiten Stufe erfolgt durch eine interne Redoxreaktion des verbliebenen Fragmentes $CuO_2C_2O_2Cu$ die Decarboxylierung unter Bildung von metallischem Kupfer und Kohlendioxid. Die erste Stufe erfolgt je nach Precursor in einem Temperaturbereich von ca. 50 bis ca. 200 °C, die zweite ab ca. 150 und ist bei ca. 350 °C abgeschlossen. Wobei jedoch die Abspaltung der Lewis-Basen und die Decarboxylierungsreaktion beim Übergang zu höheren Temperaturen durchaus parallel ablaufen können. Der Restgehalt entspricht exakt dem Kupfer-Anteil in dem entsprechenden Kupfer(I)-Precursor, so dass die Ausbeute an metallischem Kupfer mit den Verbindungen der allgemeinen Formel (II) 100 % und damit doppelt so hoch ist wie die des Stands der Technik.

Durch diese effiziente Zersetzungsreaktion entstehen mit den Verbindungen der allgemeinen Formel (II) weniger Nebenprodukte im Vergleich zum Stand der Technik. Es bildet sich im Abscheideprozess die freie Lewis-Base L' zurück, die durch entsprechende Vorrichtungen, wie Beispielsweise Kühlfallen in der Abluft, aufgefangen und wieder verwendet werden kann; als zweites Nebenprodukt entsteht Kohlendioxid. Die Nebenprodukte sind somit im Vergleich zum Stand der Technik, bei dem Kupfer(II)hexafluoroacetylacetonat und die Lewis-Base Trimethylvinylsilan als Nebenprodukte entstehen, Kupfer-frei, nicht toxisch und somit ungefährlicher. Damit ist die Umweltbelastung wesentlich geringer als die bei der Verwendung der Verbindungen des Stands der Technik.

Als thermisch stabile und am wenigstens oxidationsempfindliche Verbindung hat sich $(Norbornen)_2Cu_2O_4C_2$ erwiesen. Die Verbindung ist bis 100 °C stabil und kann über längere Zeit an der Luft gehandhabt werden. Dieses ist im Vergleich zum Stand der Technik ein enormer Fortschritt, da das CupraSelect® sich bereits ab ca. 50 °C langsam zersetzt und die Verbindung auch an Luft schnell zu Kupfer(II) oxidiert wird. Dies ermöglicht eine sehr viel einfachere Handhabung nicht nur bei der Synthese sondern auch im Abscheideprozeß.

Die Verbindungen der allgemeinen Formel (II) lassen sich als Precursor zur metallischen Kupferabscheidung verwenden. Die Abscheidung metallischer Kupferfilme kann aus der Gasphase oder aus einer Lösung aus Precursor und einem geeigneten Lösungsmittel oder aus dem festen Zustand des Precursor durch Kontakt des Precursors mit einem erhitzten Substrat erfolgen.

Zur Veranschaulichung und zum besseren Verständnis der vorliegenden Erfindung werden im folgenden Beispiele gegeben. Diese sind jedoch aufgrund der allgemeinen Gültigkeit des beschriebenen Erfindungsprinzips nicht geeignet, den Schutzbereich der vorliegenden Anmeldung nur auf diese Beispiele zu reduzieren. Weiterhin ist der Inhalt der zitierten Patentanmeldungen als Teil der Offenbarung der vorliegenden Erfindung, die der Beschreibung zugrunde liegt, anzusehen.

3. Beispiele

**Beispiel 1**

*Di[(3-hexin)kupfer(I)]oxalat*

Zu einer Suspension von 1.8 g $Cu_2O$ in 30 ml Methylenchlorid werden in einer Inertgasatmosphäre 3 ml EtC≡CEt und 1.1 g Oxalsäure gegeben und 4 Stunden bei Raumtemperatur gerührt. Zur Abtrennung unlöslicher Rückstände wird die Lösung über eine Fritte mit Kieselgel gegeben und der Rückstand auf der Fritte zweimal mit Methylenchlorid gewaschen. Die farblose Lösung wird eingeengt, und bei -30°C werden farblose Kristalle von $(EtC{\equiv}CEt)_2Cu_2O_4C_2$ erhalten.

$C_{14}H_{20}Cu_2O_4$ (379.40 g/mol). Analyse [%]: berechnet: C 44.3, H 5.3, gefunden: C 44.7, H 4.9. IR (KBr) [$cm^{-1}$]: $\nu_{C\equiv C}$ 2053, 2020 (w), $\nu_{CO2}$ 1645 (vs), 1355 (w), 1314 (m). $^1$H-NMR ($CDCl_3$): δ 1.22 (t, 12 H, $^3J$ = 7.3 Hz, $CH_3$), 2.49 (q, 8 H, $^3J$ = 7.4 Hz, $CH_2$). $^{13}C\{^1H\}$NMR ($CDCl_3$): δ 14.4 ($CH_3$), 15.5 ($CH_2$), 87.6 (C≡C), 171.4 (COO). MS (*m*/*z* (%)): 525 (7) $[M + Cu(EtC{\equiv}CEt)]^+$, 443 (7) $[M + Cu]^+$, 227 (100) $[M - CuO_4C_2]^+$, 145 (96) $[M - (EtC{\equiv}CEt)CuO_4C_2]^+$. TG (30-1000°C, 5°C/min) Dreistufenzerfall, 1. Stufe Temperaturbereich 60-120°C Gewichtsabnahme 22% (EtC≡CEt), 2. Stufe Temperaturbereich 120-150°C Gewichtsabnahme 19% (EtC=CEt), 3. Stufe Temperaturbereich 200-310°C, Gewichtsabnahme 24% (2 $CO_2$), Restgehalt 35% (2 Cu).

In Fig. 1 ist der Zerfall des hergestellten Di[(3-hexin)kupfer(I)]oxalats in Abhängigkeit von der Temperatur unter

Abscheidung einer dünnen Kupferschicht auf einem Substrat dargestellt.

**Beispiel 2**

*Di[(norbornen)kupfer(I))oxalat*

Zu einer Suspension von 1.8 g $Cu_2O$ in 50 ml Methylenchlorid werden in einer Inertgasatmosphäre 2.4 g Norbornen und 1.1 g Oxalsäure gegeben und 5 Stunden bei Raumtemperatur gerührt. Zur Abtrennung unlöslicher Rückstände wird die Lösung über eine Fritte mit Kieselgel gegeben und der Rückstand auf der Fritte zweimal mit Methylenchlorid gewaschen. Die farblose Lösung wird eingeengt, und bei -30°C werden farblose Kristalle von $(norbornen)_2Cu_2O_4C_2$ erhalten.

$C_{16}H_{20}Cu_2O_4$ (403.43 g/mol). IR (KBr) [$cm^{-1}$]: $\nu_{C=C}$ 1473 (w); $\nu_{CO2}$ 1644 (m), 1362 (m), 1303 (vs). $^1H$-NMR ($CDCl_3$) [ppm]: 1.00 (d, $^2J$ = 7.8 Hz, 2 H, $H_{endo}$), 1.03 (d, $^2J$ = 9.5 Hz, 1 H, $H_{anti}$), 1.28 (d, $^2J$ = 9.6 Hz, 1 H, $H_{syn}$), 1.59 (d, $^2J$ = 7.7 Hz, 2 H, $H_{exo}$), 3.08 (s, 2 H, CH), 5.25 (s, 2 H, =CH). $^{13}C\{^1H\}$NMR ($CDCl_3$) [ppm]: 24.4 ($CH_2CH_2$), 42.7 ($CHCH_2$), 45.7 ($CHCH_2CH$), 109.2 (=CH), 171.4 (COO). TG (30-1000°C, 5°C/min) Zweistufenzerfall, 1. Stufe Temperaturbereich 100-150°C Gewichtsabnahme 46% (2 Norbornen), 2. Stufe Temperaturbereich 200-300°C, Gewichtsabnahme 23% (2 $CO_2$), Restgehalt 31% (2 Cu).

In Fig. 2 ist der Zerfall des hergestellten Di[(norbornen)kupfer(I)]oxalats in Abhängigkeit von der Temperatur unter Abscheidung einer dünnen Kupferschicht auf einem Substrat dargestellt.

Verzeichnis der Figuren:

In Fig. 1 ist der Zerfall des gemäß Beispiel 1 hergestellten Di[(3-hexin)kupfer(I)]oxalats in Abhängigkeit von der Temperatur unter Abscheidung einer dünnen Kupferschicht auf einem Substrat dargestellt (TGA-Messung).

In Fig. 2 ist der Zerfall des gemäß Beispiel 2 hergestellten Di[(norbornen)kupfer(I)]oxalats in Abhängigkeit von der Temperatur unter Abscheidung einer dünnen Kupferschicht auf einem Substrat dargestellt (TGA-Messung).

## Patentansprüche

1. Verwendung von Verbindungen der allgemeinen Formel (II) zur Herstellung von hochreinen dünnen Kupfermetallschichten mit

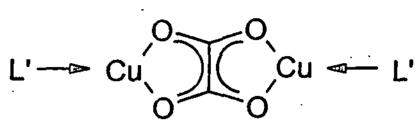

(II),

worin Kupfer in der Oxidationsstufe +1 vorliegt, und

L' ein ungesättigter Kohlenwasserstoff mit mindestens einer olefinischen oder acetylenischen Gruppe, oder CO, $PAryl_3$ oder Isonitril RN≡C
mit
R A, Aryl oder Alkylaryl
und
A geradkettig oder verzweigtes C1-C30-Alkyl, C3-C30-Cycloalkyle, geradkettig oder verzweigtes C2-C30-Alkenyl, geradkettig oder verzweigtes C3-C30-Cycloalkenyl
Aryl C6-C10-Aryle
Alkylaryl C7-C18-Alkylaryle
bedeuten, wobei Verbindungen bei denen
L' R-C=CR' mit mindestens einer Silyl- oder Estergruppe, R'HC=CHR mit mindestens einer Silyl- oder Estergruppe, $R'_3Si$-C≡C-R', $R'_3N$, $R'_2N(CH_2)_nNR'_2$, $P(OR')_3$, R'-O-R', R'-$O(CH_2)_n$-O-R', R'-S-R', R'-$S(CH_2)_n$S-R' bedeutet

mit
R A, Aryl, Alkylaryl oder Alkinyl mit mindestens einer $SiR'_3$- oder COOR'-Gruppe und
R' Alkinyl,
und
A, Aryl, Alkylaryl, Alkinyl die oben genannte Bedeutung haben,
ausgenommen sind.

**2.** Verwendung gemäß Anspruch 1, von Verbindungen der allgemeinen Formel (II), in denen

L' ein ungesättigter Kohlenwasserstoff aus der Reihe der offenkettigen C2-C30 Alkene oder zyklischen C4-C30 Alkene, der offenkettigen C2-C30 Alkine oder zyklischen C10-C30 Alkine, CO, $PAryl_3$ oder RN≡C
mit
R A
Aryl Phenyl
und
A geradkettig oder verzweigtes C1-C30-Alkyl, C3-C30-Cycloalkyl

ist.

**3.** Verwendung gemäß Anspruch 1, von Verbindungen der allgemeinen Formel (II), , in denen

L' ein ungesättigter Kohlenwasserstoff aus der Reihe der offenkettigen C2-C15 Alkene oder zyklischen C4-C15 Alkene, der offenkettigen C2-C15 Alkine oder zyklischen C10-C15 Alkine, oder CO, $P(C_6H_5)_3$ oder RN≡C
mit
R A
A geradkettig oder verzweigtes C1-C8-Alkyl, C3-C10-Cycloalkyl ist.

**4.** Verwendung gemäß Anspruch 1, von Verbindungen der allgemeinen Formel (II), in denen das offenkettige C2-C15 Alken ausgewählt ist aus Ethen, Propen, die Isomere von Buten, Penten, Hexen, Hepten, Okten, Nonen oder Decen und/oder das zyklische C4-C15 Alken ausgewählt ist aus Cyclobuten, Cyclopenten, Cyclohexen, Cyclohepten, Cyclookten, Cycopentadien, Cyclohexadien, Cyclooktadien, Norbornen, Norbornadien, die mit einem Kohlenwasserstoff substituiert sein können, und/oder das offenkettige C2-C15 Alkin ausgewählt ist aus Acetylen, Propin, die Isomere von Butin, Pentin, Hexin, Heptin, Oktin, Nonin, Decin oder Diphenylacetylen, und/oder das zyklische C10-C15 Alkin ausgewählt ist aus Cyclodecin, Cyclodecadiin, Cyclododecin oder Cycododecadiin, die mit einem Kohlenwasserstoff substituiert sein können, und /oder L' steht für die Isonitrile Cyclohexylisonitril oder Phenylisonitril.

**5.** Verwendung gemäß Anspruch 1, von Verbindungen der allgemeinen Formel (I)

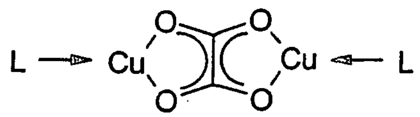

(I),

worin Kupfer in der Oxidationsstufe +1 vorliegt, und

L ein Kohlenwasserstoff aus der Reihe offenkettiges Alkin der Formel R-C≡C-R' oder zyklisches C10-C20 Alkin oder offenkettiges internes Alken der Formel R"HC=CHR"' oder zyklisches C4-C20 Alken
bedeutet
mit
R, R' H, A, Alkylaryl oder Alkinyl
R", R"' A, Aryl, Alkylaryl oder Alkinyl,
wobei L, R, R', R" und R"' jeweils unabhängig voneinander in verschiedenen Positionen des Moleküls gleiche oder verschiedene Bedeutungen annehmen können,
und
A geradkettig oder verzweigtes C1-C30-Alkyl, C3-C30-Cycloalkyle, geradkettig oder verzweigtes C2-C30-Alkenyl, geradkettig oder verzweigtes C3-C30-Cycloalkenyl
Aryl C6-C10-Aryle

Alkylaryl C7-C18-Alkylaryle
Alkinyl geradkettig oder verzweigtes C2-C30-Alkinyl
bedeuten.

6. Verfahren zur Herstellung von hochreinen dünnen Kupfermetallschichten, **dadurch gekennzeichnet, dass** Verbindungen der allgemeinen Formel (II) gemäß mindestens einem der Ansprüche 1 bis 6 erhitzt werden, wodurch die Lewis-Base L' abgespalten und metallisches Kupfer abgeschieden wird.

7. Verfahren gemäß Anspruch 6 **dadurch gekennzeichnet, dass** die Abspaltung der Lewis-Base L' in einem Temperaturbereich von 50 bis ca. 200 °C erfolgt und die Decarboxylierung unter Bildung von metallischem Kupfer in einem Temperaturbereich von 150 bis 350 °C abgeschlossen wird.

8. Verfahren gemäß mindestens einem der Ansprüche 6 oder 7 , **dadurch gekennzeichnet, dass** die abgespaltene Lewis-Base L' recycelt wird, erneut in einem Verfahren gemäß der Ansprüche 6 oder 7 eingesetzt und zur Herstellung von hochreinen dünnen metallischen Kupferschichten verwendet wird.

9. Verbindungen der allgemeinen Formel (I)

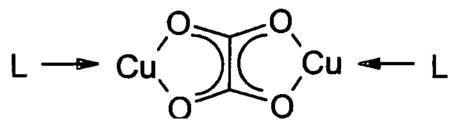

(I),

worin Kupfer in der Oxidationsstufe +1 vorliegt, und

L ein Kohlenwasserstoff aus der Reihe offenkettiges Alkin der Formel R-C≡C-R' oder zyklisches C10-C20 Alkin oder offenkettiges internes Alken der Formel R"HC=CHR"' oder zyklisches C4-C20 Alken
bedeutet
mit
R, R' H, A, Alkylaryl oder Alkinyl
R", R"' A, Aryl, Alkylaryl oder Alkinyl,
wobei L, R, R', R" und R"' jeweils unabhängig voneinander in verschiedenen Positionen des Moleküls gleiche oder verschiedene Bedeutungen annehmen können,
und
A geradkettig oder verzweigtes C1-C30-Alkyl, C3-C30-Cycloalkyle, geradkettig oder verzweigtes C2-C30-Alkenyl, geradkettig oder verzweigtes C3-C30-Cyclo alkenyl
Aryl C6-C10-Aryle
Alkylaryl C7-C18-Alkylaryle
Alkinyl geradkettig oder verzweigtes C2-C30-Alkinyl

bedeuten.

10. Verbindungen gemäß der allgemeinen Formel (I) nach Anspruch 9, worin

A geradkettiges oder verzweigtes C1-C9-Alkyl, geradkettiges oder verzweigtes C3-C9-Cycloalkyl, geradkettiges oder verzweigtes C2-C9-Alkenyl, geradkettiges oder verzweigtes C3-C9-Cycloalkenyl
Aryl Phenyl, Naphthyl,
Alkylaryl Toluyl oder Mesityl,
Alkinyl geradkettige oder verzweigte C2-C9-Alkinyle

bedeuten
und L, R, R', R" und R"' jeweils unabhängig voneinander in verschiedenen Positionen des Moleküls gleiche oder verschiedene Bedeutungen annehmen können.

11. Verbindungen gemäß der allgemeinen Formel (I) nach Anspruch 10, worin

A geradkettige oder verzweigte C1-C4-Alkyle aus der Gruppe Methyl, Ethyl, n- und i-Propyl oder n-, i- und tert-Butyl, C3-C6-Cycloalkyle aus der Gruppe Cyclopropyl, Cyclobutyl, Cyclopentyl und Cyclohexyl, geradkettiges oder verzweigtes C2-C6-Alkenyle aus der Gruppe Vinyl, Propenyl, Butenyl, Pentenyl oder Hexenyl, C3-C6-Cycloalkenyle aus der Gruppe Cyclopropenyl, Cyclobutenyl, Cyclopentenyl, Cyclopentadienyl und Methylcyclopentadienyl
Aryl Phenyl, Naphthyl,
Alkylaryl Toluyl oder Mesityl,
Alkinyl geradkettige oder verzweigte C2-C6-Alkinyle aus der Gruppe Ethinyl, Propinyl, Butinyl, Pentinyl oder Hexinyl
bedeuten,

und R, R', R'' und R''' jeweils unabhängig voneinander in verschiedenen Positionen des Moleküls gleiche oder verschiedene Bedeutungen annehmen können.

**12.** Verbindungen gemäß der allgemeinen Formel (I) nach Anspruch 9, worin L ein offenkettiges Alkin ist, ausgewählt aus der Gruppe Me-C=C-Me, Et-C≡C-Et, Pr-C≡C-Pr oder Bu-C≡C-Bu.

**13.** Verbindungen gemäß der allgemeinen Formel (I) nach Anspruch 9, worin L ein zyklisches Alkin ist, ausgewählt aus der Gruppe Cyclodecin, Cyclodecadiin, Cyclododecin, Cyclododecadiin.

**14.** Verbindungen gemäß der allgemeinen Formel (I) nach Anspruch 9, worin L ein offenkettiges internes Alken ist, ausgewählt aus der Gruppe HR''C=CHR''', worin R'', R''' unabhängig von einander $CH_3$, $C_2H_5$, $C_3H_7$, $C_4H_9$.

**15.** Verbindungen gemäß der allgemeinen Formel (I) nach Anspruch 9, worin L ein zyklisches Alken ist, ausgewählt aus der Gruppe Cyclobuten, Cyclopenten, Cyclopentadien, Cyclohexen, Cyclohexadien, Cyclohepten, Cycloheptadien, Cycloocten, Cyclooctadien, Norbornen oder Norbornadien bedeuten.

**16.** Verbindungen gemäß der allgemeinen Formel (I) nach Anspruch 9, **dadurch gekennzeichnet, dass** es sich um Di[(3-hexin)kupfer(I)]oxalat und/oder Di[(norbomen)kupfer(I)]oxalat handelt.

**17.** Verfahren zur Herstellung der Verbindungen der allgemeinen Formel (I) gemäß mindestens einem der Ansprüche 9 bis 16, **dadurch gekennzeichnet, dass** $Cu_2O$ mit Oxalsäure und einer Lewis-Base L in einem inerten Lösungsmittel umgesetzt wird und das hergestellte Produkt isoliert wird.

**18.** Verfahren gemäß Anspruch 17, **dadurch gekennzeichnet, dass** ein inertes aprotisches organisches Lösungsmittel verwendet wird, bei dem es sich um offenkettige oder zyklische aliphatische oder aromatische Kohlenwasserstoffe, um halogenierte aliphatische oder halogenierte aromatische Kohlenwasserstoffe oder um lineare oder cyclische Ether oder um Gemische dieser Kohlenwasserstoffe handelt, wobei das Lösungsmittel vorzugsweise ausgewählt ist aus der Gruppe Pentan, Hexan, Heptan, Cyclohexan, Toluol, Methylenchlorid, Trichlormethan, Chlorbenzol, Diethylether oder Tetrahydrofuran.

**19.** Verfahren gemäß Anspruch 17, **dadurch gekennzeichnet, dass** es unter Schutzgasatmosphäre durchgeführt wird, wobei vorzugsweise als Schutzgas Stickstoff oder Argon eingesetzt wird.

**20.** Verfahren gemäß Anspruch 17, **dadurch gekennzeichnet, dass** die Lewis-Base L im Überschuss bezogen auf das stöchiometrische Verhältnis der Edukte $Cu_2O$ und Oxalsäure eingesetzt wird, mindestens aber im doppelten stöchiometrischen Verhältnis.

**21.** Verfahren gemäß mindestens einem der Ansprüche 17 bis 20, **dadurch gekennzeichnet, dass** die Edukte $Cu_2O$, Oxalsäure und Lewis-Base L im stöchiometrischen Verhältnis 1 : 1 : 2 bis 1 : 1 : 4 eingesetzt werden.

**22.** Verfahren gemäß einem oder mehreren der Ansprüche 17-20, **dadurch gekennzeichnet, dass** zwei verschiedene Lewis-Basen L in gleichen molaren Mengen eingesetzt werden.

**23.** Verfahren gemäß einem oder mehreren der Ansprüche 17 - 22, **dadurch gekennzeichnet, dass** die Umsetzung innerhalb einer Reaktionszeit von 1 bis 24 Stunden in einem Temperaturbereich von -30 bis +100 °C, vorzugsweise bei Raumtemperatur durchgeführt wird.

**24.** Verfahren gemäß einem oder mehreren der Ansprüche 17 bis 23, **dadurch gekennzeichnet, dass** nach erfolgter

Reaktion unlösliche Bestandteile, vorzugsweise durch Extraktion, abgetrennt werden und das Reaktionsprodukt aus der Lösung isoliert und gegebenenfalls gereinigt wird, oder dass das Reaktionsprodukt durch Extraktion vom Reaktionsgemisch abgetrennt, isoliert und gegebenenfalls gereinigt wird.

## Claims

1. Use of compounds of the general formula (II) for the production of high-purity thin copper-metal layers

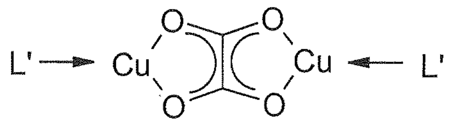

(II),

in which copper is in oxidation state +1, and

L' is an unsaturated hydrocarbon containing at least one olefinic or acetylenic group,
or CO, $P(aryl)_3$ or isonitrile RN=C,
where
R is A, aryl or alkylaryl
and
A is straight-chain or branched C1-C30-alkyl, C3-C30-cycloalkyl, straight-chain or branched C2-C30-alkenyl, or straight-chain or branched C3-C30-cycloalkenyl,
aryl is C6-C10-aryl,
alkylaryl is C7-C18-alkylaryl,
excluding compounds where
L' is R-C≡CR' having at least one silyl or ester group, R'HC=CHR having at least one silyl or ester group, $R'_3Si-C\equiv C-R'$, $R'_3N$, $R'_2N(CH_2)_nNR'_2$, $P(OR')_3$, R'-O-R', $R'-O(CH_2)_n-O-R'$, R'-S-R', $R'-S(CH_2)_nS-R'$
where
R is A, aryl, alkylaryl or alkynyl having at least one $SiR'_3$ or COOR' group and
R' is alkynyl,
and
A, aryl, alkylaryl and alkynyl are each as defined above.

2. Use according to Claim 1 of compounds of the general formula (II) in which

L' is an unsaturated hydrocarbon from the series consisting of open-chain C2-C30-alkenes and cyclic C4-C30-alkenes, open-chain C2-C30-alkynes and cyclic C10-C30-alkynes, CO, $P(aryl)_3$ and RN≡C,
where
R is A,
aryl is phenyl
and
A is straight-chain or branched C1-C30-alkyl or C3-C30-cycloalkyl.

3. Use according to Claim 1 of compounds of the general formula (II) in which

L' is an unsaturated hydrocarbon from the series consisting of open-chain C2-C15-alkenes and cyclic C4-C15-alkenes, open-chain C2-C15-alkynes and cyclic C10-C15*-alkynes, CO, $P(C_6H_5)_3$ and RN≡C,
where
R is A and
A is straight-chain or branched C1-C8-alkyl or C3-C10-cycloalkyl.

4. Use according to Claim 1 of compounds of the general formula (II) in which open-chain C2-C15-alkene is selected from ethene, propene, the isomers of butene, pentene, hexene, heptene, octene, nonene or decene, and/or cyclic C4-C15-alkene is selected from cyclobutene, cyclopentene, cyclohexene, cycloheptene, cyclooctene, cyclopentadiene, cyclohexadiene, cyclooctadiene, norbornene or norbornadiene, which may be substituted by a hydrocarbon,

and/or open-chain C2-C15-alkyne is selected from acetylene, propyne, the isomers of butyne, pentyne, hexyne, heptyne, octyne, nonyne, decyne or diphenylacetylene, and/or cyclic C10-C15-alkyne is selected from cyclodecyne, cyclodecadiyne, cyclododecyne or cyclododecadiyne, which may be substituted by a hydrocarbon, and/or L' is one of the isonitriles cyclohexyl isonitrile or phenyl isonitrile.

**5.** Use according to Claim 1 of compounds of the general formula (I)

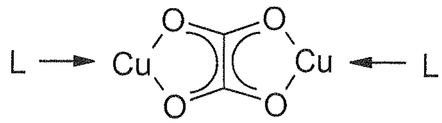

(I),

in which copper is in oxidation state +1, and

L is a hydrocarbon from the series consisting of open-chain alkyne of the formula R-C=C-R' and cyclic C10-C20-alkyne and open-chain internal alkene of the formula R"HC=CHR"' and cyclic C4-C20-alkene,
where
R and R' are H, A, alkylaryl or alkynyl,
R" and R"' are A, aryl, alkylaryl or alkynyl,
where L, R, R', R" and R"' may each, independently of one another, adopt identical or different meanings in different positions of the molecule,
and
A A is straight-chain or branched C1-C30-alkyl, C3-C30-cycloalkyl, straight-chain or branched C2-C30-alkenyl or straight-chain or branched C3-C30-cycloalkenyl,
aryl is C6-C10-aryl,
alkylaryl is C7-C18-alkylaryl,
alkynyl is straight-chain or branched C2-C30-alkynyl.

**6.** Process for the production of high-purity thin copper-metal layers, **characterised in that** compounds of the general formula (II) according to at least one of Claims 1 to 5 are heated, causing the elimination of the Lewis base L' and deposition of metallic copper.

**7.** Process according to Claim 6, **characterised in that** the elimination of the Lewis base L' is carried out in a temperature range of from 50 to about 200°C, and the decarboxylation with formation of metallic copper is completed in a temperature range of from 150 to 350°C.

**8.** Process according to at least one of Claims 6 and 7, **characterised in that** the eliminated Lewis base L' is recycled, re-employed in a process according to Claim 6 or 7 and used for the production of high-purity thin metallic copper layers.

**9.** Compounds of the general formula (I)

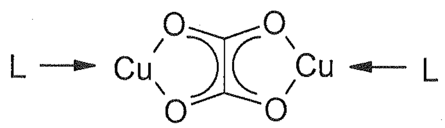

(I),

in which copper is in oxidation state +1, and

L is a hydrocarbon from the series consisting of open-chain alkyne of the formula R-C≡C-R' and cyclic C10-C20-alkyne and open-chain internal alkene of the formula R"HC=CHR"' and cyclic C4-C20-alkene,
where
R and R' are H, A, alkylaryl or alkynyl,
R" and R"' are A, aryl, alkylaryl or alkynyl,
where L, R, R', R" and R"' may each, independently of one another, adopt identical or different meanings in

different positions of the molecule,
and
A is straight-chain or branched C1-C30-alkyl, C3-C30-cycloalkyl, straight-chain or branched C2-C30-alkenyl, or straight-chain or branched C3-C30-cycloalkenyl,
aryl is C6-C10-aryl,
alkylaryl is C7-C18-alkylaryl,
alkynyl is straight-chain or branched C2-C30-alkynyl.

**10.** Compounds of the general formula (I) according to Claim 9, in which

A is straight-chain or branched C1-C9-alkyl, straight-chain or branched C3-C9-cycloalkyl, straight-chain or branched C2-C9-alkenyl, or straight-chain or branched C3-C9-cycloalkenyl,
aryl is phenyl or naphthyl,
alkylaryl is tolyl or mesityl,
alkynyl is straight-chain or branched C2-C9-alkynyl,

and L, R, R', R" and R"' may each, independently of one another, adopt identical or different meanings in different positions of the molecule.

**11.** Compounds of the general formula (I) according to Claim 9, in which

A is straight-chain or branched C1-C4-alkyl from the group consisting of methyl, ethyl, n- and i-propyl and n-, i- and tert-butyl, C3-C6-cycloalkyl from the group consisting of cyclopropyl, cyclobutyl, cyclopentyl and cyclohexyl, straight-chain or branched C2-C6-alkenyl from the group consisting of vinyl, propenyl, butenyl, pentenyl and hexenyl, or C3-C6-cycloalkenyl from the group consisting of cyclopropenyl, cyclobutenyl, cyclopentenyl, cyclopentadienyl and methylcyclopentadienyl,
aryl is phenyl or naphthyl,
alkylaryl is tolyl or mesityl,
alkynyl is straight-chain or branched C2-C6-alkynyl from the group consisting of ethynyl, propynyl, butynyl, pentynyl and hexynyl,

and R, R', R" and R"' may each, independently of one another, adopt identical or different meanings in different positions of the molecule.

**12.** Compounds of the general formula (I) according to Claim 9, in which L is an open-chain alkyne selected from the group consisting of Me-C≡C-Me, Et-C≡C-Et, Pr-C≡C-Pr and Bu-C≡C-Bu.

**13.** Compounds of the general formula (I) according to Claim 9, in which L is a cyclic alkyne selected from the group consisting of cyclodecyne, cyclodecadiyne, cyclododecyne and cyclododecadiyne.

**14.** Compounds of the general formula (I) according to Claim 9, in which L is an open-chain internal alkene selected from the group consisting of HR"C=CHR"', in which R" and R"' are, independently of one another, $CH_3$, $C_2H_5$, $C_3H_7$ or $C_4H_9$.

**15.** Compounds of the general formula (I) according to Claim 9, in which L is a cyclic alkene selected from the group consisting of cyclobutene, cyclopentene, cyclopentadiene, cyclohexene, cyclohexadiene, cycloheptene, cycloheptadiene, cyclooctene, cyclooctadiene, norbornene and norbornadiene.

**16.** Compounds of the general formula (I) according to Claim 9, **characterised in that** they are di[(3-hexyne)copper(I)] oxalate and/or di[(norbornene)-copper(I)] oxalate.

**17.** Process for the preparation of the compounds of the general formula (I) according to at least one of Claims 9 to 16, **characterised in that** $Cu_2O$ is reacted with oxalic acid and a Lewis base L in an inert solvent, and the resultant product is isolated.

**18.** Process according to Claim 17, **characterised in that** an inert aprotic organic solvent is used which is an open-chain or cyclic aliphatic or aromatic hydrocarbon, a halogenated aliphatic or halogenated aromatic hydrocarbon or a linear or cyclic ether or a mixture of these hydrocarbons, where the solvent is preferably selected from the group

consisting of pentane, hexane, heptane, cyclohexane, toluene, methylene chloride, trichloromethane, chlorobenzene, diethyl ether and tetrahydrofuran.

**19.** Process according to Claim 17, **characterised in that** it is carried out under a protective-gas atmosphere, where the protective gas employed is preferably nitrogen or argon.

**20.** Process according to Claim 17, **characterised in that** the Lewis base L is employed in excess relative to the stoichiometric ratio of the starting materials $Cu_2O$ and oxalic acid, but at least in twice the stoichiometric ratio.

**21.** Process according to at least one of Claims 17 to 20, **characterised in that** the starting materials $Cu_2O$, oxalic acid and Lewis base L are employed in a stoichiometric ratio of from 1:1:2 to 1:1:4.

**22.** Process according to one or more of Claims 17-20, **characterised in that** two different Lewis bases L are employed in the same molar amounts.

**23.** Process according to one or more of Claims 17 - 22, **characterised in that** the reaction is carried out within a reaction time of from 1 to 24 hours in a temperature range of from -30 to +100°C, preferably at room temperature.

**24.** Process according to one or more of Claims 17 to 23, **characterised in that**, when the reaction is complete, insoluble constituents are separated off, preferably by extraction, and the reaction product is isolated from the solution, and, if necessary, purified, or **in that** the reaction product is separated off from the reaction mixture by extraction, isolated and, if necessary, purified.

## Revendications

**1.** Utilisation de composés de la formule générale (II) servant à la fabrication de fines couches métalliques en cuivre de pureté élevée avec :

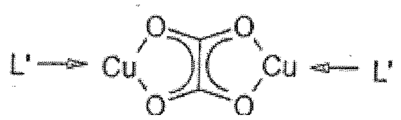

(II)

où le cuivre est présent à l'état d'oxydation +1, et

L' est un hydrocarbure insaturé avec au moins un groupe oléfinique ou acétylé,
ou CO, $Paryle_3$ ou isonitrile RN≡C
où
R est A, un aryle ou alkylaryle
et
A un alkyle en $C_1$-$C_{30}$ linéaire ou ramifié, cycloalkyle en $C_3$-$C_{30}$, un alcényle en $C_2$-$C_{30}$ linéaire ou ramifié, un cycloalcényle en $C_3$-$C_{30}$ linéaire ou ramifié
l'aryle un aryle en $C_6$-$C_{10}$
l'alkylaryle est un alkylaryle en $C_7$-$C_{18}$,
où des composés dans lesquels
L' est R-C≡CR' avec au moins un groupe silyle ou ester, R'HC=CHR avec au moins un groupe silyle ou ester, $R'_3Si$-C≡C-R', $R'_3N$, $R'_2N(CH_2)_nNR'_2$, $P(OR')_3$, R'-O-R', R'-$O(CH_2)_n$-O-R', R'-S-R', R'-$S(CH_2)_n$S-R'
où
R est A, un aryle, un alkylaryle ou alcinyle avec au moins un groupe $SiR'_3$ ou COOR' et
R' un alcinyle,
et
A, l'aryle, l'alkylaryle, l'alcinyle ont les significations ci-dessus sont exclus.

**2.** Utilisation selon la revendication 1 de composés de la formule générale (II), dans lesquels

L' L' est un hydrocarbure insaturé de la série des alcènes en $C_2$-$C_{30}$ à chaîne ouverte ou des alcènes en $C_4$-$C_{30}$ cycliques, des alcines en $C_2$-$C_{30}$ à chaîne ouverte ou des alcines en $C_{10}$-$C_{30}$ cycliques, CO, $Paryle_3$ ou RN≡C

où
R est A
l'aryle est un phényle
et
A est un alkyle en $C_1$-$C_{30}$ linéaire ou ramifié, un cycloalkyle en $C_3$-$C_{30}$.

**3.** Utilisation selon la revendication 1 de composés de la formule générale (II) dans lesquels

L' est un hydrocarbure insaturé de la série des alcènes en $C_2$-$C_{15}$ à chaîne ouverte ou des alcènes en $C_4$-$C_{15}$ cycliques, des alcines en $C_2$-$C_{15}$ à chaîne ouverte ou des alcines en $C_{10}$-$C_{15}$ cycliques, ou CO, $P(C_6H_5)_3$ ou RN=C
où
R est A
A est un alkyle en $C_1$-$C_8$ linéaire ou ramifié, un cycloalkyle en $C_3$-$C_{10}$.

**4.** Utilisation selon la revendication 1 de composés de la formule générale (II), dans lesquels l'alcène en $C_2$-$C_{15}$ à chaîne ouverte est choisi parmi l'éthène, le propène, les isomères de butène, pentène, hexène, heptène, octène, nonène ou décène et/ou l'alcène en $C_4$-$C_{15}$ cyclique est choisi parmi le cyclobutène, le cyclopentène, le cyclohexène, le cycloheptène, le cyclooctène, le cyclopentadiène, le cyclohexadiène, le cyclooctadiène, le norbornène, le norbornadiène, qui peuvent être substitués avec un hydrocarbure, et/ou l'alcine en $C_2$-$C_{15}$ à chaîne ouverte est choisi parmi l'acétylène, le propine, les isomères de butine, pentine, hexine, heptine, octine, nonine, décine ou diphénylacétylène, et/ou l'alcine en $C_{10}$-$C_{15}$ cyclique est choisi parmi le cyclodécine, cyclodécadine, cyclododécine ou cyclododécadine, qui peuvent être substitués avec un hydrocarbure, et/ou L' correspond aux isonitriles cyclohexylisonitrile ou phénylisonitrile.

**5.** Utilisation selon la revendication 1 de composés de la formule générale (I) :

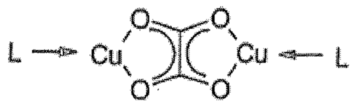
(I),

où le cuivre est présent dans l'état d'oxydation +1, et

L est un hydrocarbure de la série de l'alcine à chaîne ouverte de formule R-C≡C-R' ou un alcine en $C_{10}$-$C_{20}$ cyclique ou un alcène interne à chaîne ouverte de formule R"HC = CHR"' ou un alcène en $C_4$-$C_{20}$ cyclique
où
R, R' sont H, A, un alkylaryle ou un alcinyle
R", R"' sont A, un aryle, un alkylaryle ou un alcinyle,
où L, R, R', R" et R"' peuvent prendre des significations similaires ou différentes indépendamment les uns des autres en différentes positions de la molécule,
et
A est un alkyle en $C_1$-$C_{30}$ linéaire ou ramifié, un cycloalkyle en $C_3$-$C_{30}$, un alcényle en $C_2$-$C_{30}$ linéaire ou ramifié, un cycloalcényle en $C_3$-$C_{30}$ linéaire ou ramifié
l'aryle est un aryle en $C_6$-$C_{10}$
l'alkylaryle est un alkylaryle en $C_7$-$C_{18}$
l'alcinyle est un alcinyle en $C_2$-$C_{30}$ linéaire ou ramifié.

**6.** Procédé servant à la fabrication de fines couches métalliques de cuivre de pureté élevée **caractérisé en ce que** les composés de la formule générale (II) selon au moins l'une des revendications 1 à 5 sont chauffés, grâce à quoi la base de Lewis L' est séparée et le cuivre métallique est isolé.

**7.** Procédé selon la revendication 6 **caractérisé en ce que** la séparation de la base de Lewis L' a lieu dans une plage de températures de 50 à 200° C environ et la décarboxylation s'achève avec la formation de cuivre métallique dans une plage de température de 150 à 350° C.

**8.** Procédé selon au moins l'une quelconque des revendications 6 ou 7, **caractérisé en ce que** la base de Lewis L'

isolée est recyclée, est utilisée à nouveau dans un procédé selon la revendication 6 ou 7 et utilisée pour la fabrication de fines couches de cuivre métallique de pureté élevée.

**9.** Composés selon la formule générale (I) :

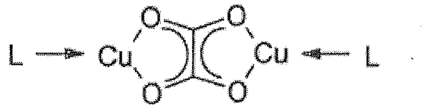

(I)

où le cuivre est présent à l'état d'oxydation +1, et

L est un hydrocarbure de la série de l'alcine à chaîne ouverte de la formule R-C≡C-R' ou de l'alcine en $C_{10}$-$C_{20}$ cyclique ou de l'alcène interne à chaîne ouverte de la formule R"HC = CHR"' ou de l'alcène en $C_4$-$C_{20}$ cyclique où
R, R' est H, A, un alkylaryle ou un alcinyle
R", R"' est A, un aryle, un alkylaryle ou un alcinyle,
où L, R, R', R" et R"' peuvent prendre des significations similaires ou différentes en différentes positions de la molécule indépendamment les uns des autres,
et
A est un alkyle en $C_1$-$C_{30}$ linéaire ou ramifié, un cycloalkyle en $C_3$-$C_{30}$, un alcényle en $C_2$-$C_{30}$ linéaire ou ramifié, un cycloalcényle en $C_3$-$C_{30}$ linéaire ou ramifié
l'aryle est un aryle en $C_6$-$C_{10}$
l'alkylaryle est un alkylaryle en $C_7$-$C_{18}$
l'alcinyle est un alcinyle en $C_2$-$C_{30}$ linéaire ou ramifié.

**10.** Composés de la formule générale (I) selon la revendication 9, dans lesquels

A est un alkyle en $C_1$-$C_9$ linéaire ou ramifié, un cycloalkyle en $C_3$-$C_9$ linéaire ou ramifié, un alcényle en $C_2$-$C_9$ linéaire ou ramifié, un cycloalcényle en $C_3$-$C_9$ linéaire ou ramifié
l'aryle est un phényle, un napthyle,
l'alkylaryle est un toluyle ou un mésityle,
l'alcinyle est un alcinyle en $C_2$-$C_9$ linéaire ou ramifié
et
où L, R, R', R" et R"' peuvent prendre des significations similaires ou différentes en différentes positions de la molécule indépendamment les uns des autres.

**11.** Composés de la formule générale (I) selon la revendication 9, dans lesquels

A est un alkyle en $C_1$-$C_4$ linéaire ou ramifié du groupe du méthyle, de l'éthyle, du n- et i-propyle ou n-, i- et tert-butyle, un cycloalkyle en $C_3$-$C_6$ du groupe formé du cyclopropyle, cyclobutyle, cyclopentyle et cyclohexyle, un alcényle en $C_2$-$C_6$ linéaire ou ramifié du groupe constitué par le vinyle, le propényle, le butényle, le pentényle ou l'hexényle, un cycloalcényle en $C_3$-$C_6$ du groupe formé du cyclopropényle, cyclobutényle, cyclopentényle, cyclopentadiényle et méthylcyclopentadiényle
l'aryle est un phényle, un napthyle,
l'alkylaryle est un toluyle ou un mésityle,
l'alcinyle est un alcinyle en $C_2$-$C_6$ linéaire ou ramifié du groupe formé de l'éthinyle, du propinyle, du butinyle, du pentinyle ou de l'hexinyle,
et
R, R', R" et R"' peuvent prendre des significations similaires ou différentes en différentes positions de la molécule indépendamment les uns des autres.

**12.** Composés de la formule générale (I) selon la revendication 9, dans lesquels L est un alcine à chaîne ouverte, choisi dans le groupe formé de MeC=C-Me, Et-C≡C-Et, Pr-C≡C-Pr ou Bu-C≡C-Bu.

**13.** Composés de la formule générale (I) selon la revendication 9, dans lesquels L est un alcine cyclique, choisi dans

le groupe du cyclodécine, cyclodécadine, cyclododécine, cyclododécadine.

**14.** Composés de la formule générale (I) selon la revendication 9, dans lesquels L est un alcène interne à chaîne ouverte, choisi dans le groupe HR"C = CHR"', dans lesquels R", R"' sont indépendamment les uns des autres $CH_3$, $C_2H_5$, $C_3H_7$, $C_4H_9$.

**15.** Composés de la formule générale (I) selon la revendication 9, dans lesquels L est un alcène cyclique, choisi dans le groupe du cyclobutène, cyclopentène, cyclopentadiène, cyclohexène, cyclohexadiène, cycloheptène, cycloheptadiène, cyclooctène, cyclooctadiène, norbornène ou norbornadiène.

**16.** Composés de la formule générale (I) selon la revendication 9, **caractérisés en ce qu'**il s'agit d'oxalate de di[(3-hexine)cuivre(I)] et/ou d'oxalate de di((norbornène)cuivre(I)].

**17.** Procédé servant à la fabrication de composés de la formule générale (I) selon au moins l'une des revendications 9 à 16, **caractérisés en ce que** $Cu_20$ est transformé avec de l'acide oxalique et une base de Lewis L dans un solvant inerte et le produit fabriqué est isolé.

**18.** Procédé selon la revendication 17, **caractérisés en ce qu'**on utilise un solvant organique aprotique inerte, dans lequel il s'agit d'un hydrocarbure aliphatique ou aromatique cyclique ou à chaîne ouverte, d'un hydrocarbure aromatique halogéné ou aliphatique halogéné ou d'un éther cyclique ou linéaire ou de mélanges de ces hydrocarbures, le solvant étant choisi de préférence dans le groupe formé par le pentane, l'hexane, l'heptane, le cyclohexane, le toluol, le chlorure de méthylène, le trichlorométhane, le chlorobenzène, le diéthyléther ou le tétrahydrofurane.

**19.** Procédé selon la revendication 17, **caractérisé en ce qu'**il est réalisé dans une atmosphère de gaz protecteur, le gaz protecteur utilisé étant de préférence de l'azote ou de l'argon.

**20.** Procédé selon la revendication 17, **caractérisé en ce que** la base de Lewis L est utilisée en excédent par rapport au ratio stoechiométrique de l'éduit $Cu_2O$ et d'acide oxalique, mais au moins égal au double du ratio stoechiométrique.

**21.** Procédé selon au moins l'une quelconque des revendications 17 à 20, **caractérisé en ce que** l'éduit $Cu_2O$, l'acide oxalique et la base de Lewis L sont employés dans un ratio stoechiométrique de 1:1:2 à 1:1:4.

**22.** Procédé selon l'une quelconque ou plusieurs des revendications 17-20, **caractérisé en ce que** deux bases de Lewis L sont utilisées dans la même quantité molaire.

**23.** Procédé selon l'une quelconque ou plusieurs des revendications 17-22, **caractérisé en ce que** la réaction est réalisée dans un délai de réaction de 1 à 24 heures dans une plage de températures de -30 à +100° C, de préférence à température ambiante.

**24.** Procédé selon l'une quelconque ou plusieurs des revendications 17 à 23, **caractérisé en ce que**, après le succès de la réaction, des composants insolubles sont isolés, de préférence par extraction, et le produit de réaction est isolé de la solution et le cas échéant purifié, ou **en ce que** le produit de réaction est séparé par extraction du mélange réactif, isolé et le cas échéant purifié.

Fig. 1

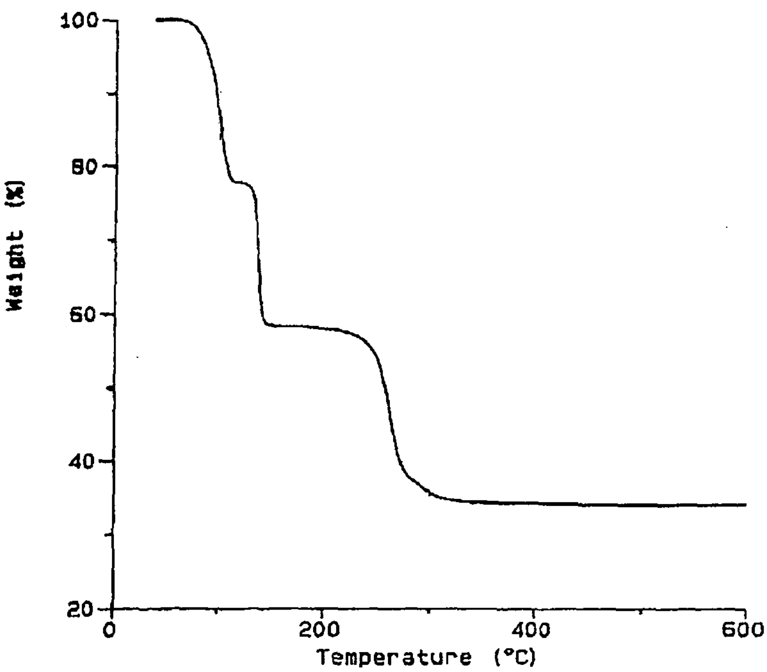

Fig. 2

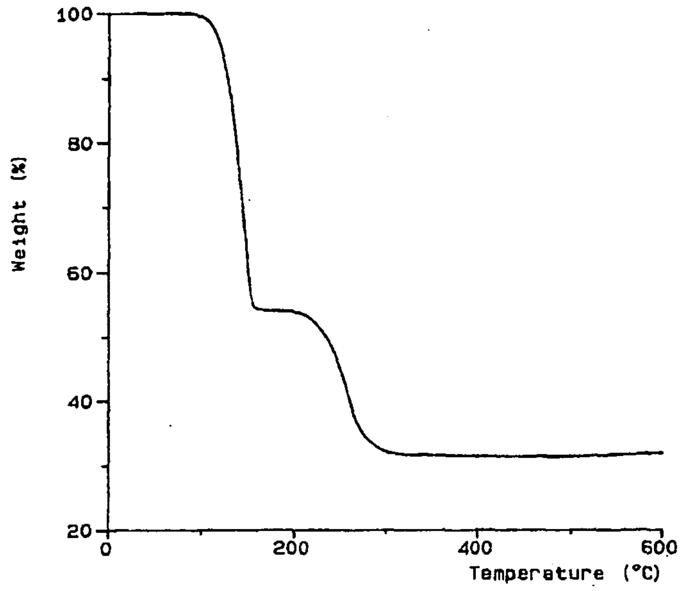

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5220044 A
- WO 0071550 A
- WO 0017278 A
- US 6130345 A
- WO 0008225 A
- US 5441766 A
- EP 0468396 A
- EP 0297348 A
- DE 4123686
- WO 2004000850 A

### In der Beschreibung aufgeführte Nicht-Patentliteratur

- *Chem. Mater.,* 2001, vol. 13, 3993
- *Inorg. Chem.,* 2001, vol. 40, 6167
- *Chem. Mater.,* 1992, vol. 4, 365
- *Organometallics,* 2001, vol. 20, 4001
- *Chem. Ber.,* 1995, vol. 128, 525
- *MRS Bulletin,* August 1994, 41
- *Chem. Mater.,* 1992, vol. 4, 577